# EUROPEAN PATENT APPLICATION

(11) **EP 4 734 377 A1**
(43) Date of publication of application: **29.04.2026**
(21) Application number: 24844186.7
(22) Date of filing: 29.01.2024
(51) Int. Cl.: H03M 7/30

(54) **DATA COMPRESSION METHOD AND APPARATUS, DATA DECOMPRESSION METHOD AND APPARATUS, AND STORAGE SYSTEM**

(30) Priority: 27.07.2023 RU 2023119769
(71) Applicant: Huawei Technologies Co., Ltd., Shenzhen, Guangdong 518129 (CN)
(72) Inventor: GUAN, Kun, Shenzhen, Guangdong 518129 (CN); LIU, Bang, Shenzhen, Guangdong 518129 (CN); QUAN, Shaohui, Shenzhen, Guangdong 518129 (CN)
(74) Representative: Pfenning, Meinig & Partner mbB
(86) International application number: PCT/CN2024/074423
(87) International publication number: WO 2025/020487

(57) **Abstract**

A data compression method and apparatus, and a storage system are provided. The method includes: acquiring a first data block set, where the first data block set includes a plurality of similar data blocks, and the plurality of data blocks include a target data block; determining a target reference data block based on a similarity tree corresponding to the first data block set, where the similarity tree is of a tree structure, the similarity tree includes a plurality of parent-child node pairs, each parent-child node pair indicates two data blocks that meet a similarity condition in the first data block set, the plurality of parent-child node pairs include a target parent-child node pair that indicates the target reference data block and the target data block, and a node that is in the target parent-child node pair and that corresponds to the target reference data block is a parent node of a node corresponding to the target data block; and performing reference-based compression on the target data block based on the target reference data block, to obtain a target data block after the compression. According to the method, when compressed data is decompressed, resource overheads can be reduced and a waste of a large quantity of computing resources can be avoided.

## Description

This application claims priority to Russian Patent Application No. 2023119769, filed on July 27, 2023 and entitled "DATA COMPRESSION METHOD AND APPARATUS, DATA DECOMPRESSION METHOD AND APPARATUS, AND STORAGE SYSTEM", which is incorporated herein by reference in its entirety.

### TECHNICAL FIELD

This application relates to the field of data compression, and more specifically, to a data compression method and apparatus, a data decompression method and apparatus, and a storage system.

### BACKGROUND

With continuous improvement of informatization and rapid development of big data, cloud computing, and artificial intelligence technologies, a demand of an enterprise for data increases explosively. Such a large amount of data inevitably brings great pressure to data storage management. Therefore, data reduction or compression is a key technology in storage systems to improve storage space utilization and meet rapidly growing storage requirements with a limited storage capacity.

Similarity-based compression is an implementation of the data compression. Compared with a deduplication technology that has a constraint that requires data blocks to be exactly the same to eliminate redundant data, a similarity deduplication technology has a significant reduction effect for data blocks that are incompletely identical but have a specific degree of similarity.

In a related technical solution of the similarity-based compression, when the similarity-based compression is performed, similarities between similar data blocks exhibit a linear relationship. To be specific, in a process of performing reference-based compression on the data blocks, one data block is compressed based on all data blocks previous to the data block. This means that, in a process of decompressing data blocks, decompressing one of the data blocks depends on all previous data blocks in the linear relationship. In this case, computing resource overheads are increased.

Therefore, when compressed data is decompressed, how to reduce resource overheads and avoid a waste of a large quantity of computing resources becomes a technical problem that needs to be urgently resolved currently.

### SUMMARY

This application provides a data compression method and apparatus, a data decompression method and apparatus, and a storage system. According to the method, when compressed data is decompressed, resource overheads can be reduced and a waste of a large quantity of computing resources can be avoided.

According to a first aspect, a data compression method is provided. The method includes: acquiring a first data block set, where the first data block set includes a plurality of similar data blocks, and the plurality of data blocks include a target data block; determining a target reference data block based on a similarity tree corresponding to the first data block set, where the similarity tree is of a tree structure, the similarity tree includes a plurality of parent-child node pairs, each parent-child node pair indicates two data blocks that meet a similarity condition in the first data block set, the plurality of parent-child node pairs include a target parent-child node pair that indicates the target reference data block and the target data block, and a node that is in the target parent-child node pair and that corresponds to the target reference data block is a parent node of a node corresponding to the target data block; and performing reference-based compression on the target data block based on the target reference data block, to obtain a target data block after the compression.

In the foregoing technical solution, similarity-based compression is performed on the target data block based on the target reference data block determined based on the similarity tree of the tree structure. In the similarity tree, the node corresponding to the target reference data block is the parent node of the node of the target data block. Because the target data block is compressed based on the target reference data block, and the node corresponding to the target data block and the node corresponding to the target reference data block have a parent-child relationship in the similarity tree, during decompression of data blocks, decompression of one of the data blocks depends only on a data block on a path of a root node, and depends on none of previous data blocks in a linear relationship. Therefore, during the decompression, resource overheads can be reduced, a waste of a large quantity of computing resources can be avoided, and performance can be improved while a compression rate is ensured.

With reference to the first aspect, in some implementations of the first aspect, the method further includes: constructing the similarity tree based on respective similar fingerprints of the plurality of data blocks.

In the foregoing technical solution, the similarity tree constructed based on the respective similar fingerprints of the plurality of data blocks may be used to compress or decompress the data blocks, so that in a data decompression process, the resource overheads can be reduced, the waste of the large quantity of computing resources can be avoided, and the performance can be improved while the compression rate is ensured.

With reference to the first aspect, in some implementations of the first aspect, the plurality of parent-child node pairs are determined based on the respective similar fingerprints of the plurality of data blocks; and the similarity tree is constructed based on the plurality of parent-child node pairs.

With reference to the first aspect, in some implementations of the first aspect, a data block is selected from the first data block set as the root node of the similarity tree, a child node corresponding to the root node is determined based on the respective similar fingerprints of the plurality of data blocks and a similarity condition, the root node and the child node corresponding to the root node are then used as parent nodes, and child nodes corresponding to the parent nodes are determined based on respective similar fingerprints of other data blocks and a similarity condition.

With reference to the first aspect, in some implementations of the first aspect, the similarity tree corresponding to the first data block set may be constructed by determining, based on the respective similar fingerprints of the plurality of data blocks in the first data block set, a plurality of parent-child node pairs that meet a condition, and combining the parent-child node pairs.

With reference to the first aspect, in some implementations of the first aspect, the method further includes: storing information about the similarity tree in a plurality of compressed data blocks corresponding to the first data block set, where the stored information about the similarity tree is used to decompress the plurality of compressed data blocks corresponding to the first data block set.

In the foregoing technical solution, the information about the similarity tree may be stored in the plurality of compressed data blocks corresponding to the first data block set. In this way, when the plurality of compressed data blocks corresponding to the first data block set are decompressed, reference data blocks of the compressed data blocks can be determined based on the information about the similarity tree, so that in the data decompression process, the resource overheads can be reduced, the waste of the large quantity of computing resources can be avoided, and the performance can be improved while the compression rate is ensured.

With reference to the first aspect, in some implementations of the first aspect, the information about the similarity tree includes information about the parent-child node pairs in the similarity tree.

In the foregoing technical solution, information about a parent-child node pair in the similarity tree may be stored in a data block after compression. In this way, when the data block after the compression is decompressed, a reference data block can be directly determined based on the information about the parent-child node pair, and an entire similarity tree does not need to be constructed, so that the computing resources are further reduced.

With reference to the first aspect, in some implementations of the first aspect, the information about the similarity tree includes the similar fingerprints of the data blocks in the first data block set.

In the foregoing technical solution, the similar fingerprints of the data blocks in the first data block set may be further stored in a data block after compression. In this way, when the data block after the compression is decompressed, the similarity tree may be first constructed based on the similar fingerprints of the data blocks, and a reference data block is determined based on information about the parent-child node pairs in the similarity tree.

With reference to the first aspect, in some implementations of the first aspect, the information about the similarity tree is stored in any one of the plurality of compressed data blocks corresponding to the first data block set.

With reference to the first aspect, in some implementations of the first aspect, the information about the similarity tree is stored in a compressed data block corresponding to the root node of the similarity tree.

In the foregoing technical solution, during decompression of any data block, the compressed data block corresponding to the root node needs to be decompressed. Therefore, the information about the similarity tree is stored in the compressed data block corresponding to the root node of the similarity tree, so that the resource overheads are further reduced.

With reference to the first aspect, in some implementations of the first aspect, one parent node in the similarity tree includes at least one child node.

According to a second aspect, a data decompression method is provided. The method includes: acquiring compressed data, where the compressed data includes a plurality of compressed data blocks corresponding to a first data block set and information about a similarity tree corresponding to the first data block set, the plurality of compressed data blocks include a first compressed data block, the first compressed data block is obtained by compressing a target data block in the first data block set, the similarity tree is of a tree structure, the similarity tree includes a plurality of parent-child node pairs, and each parent-child node pair indicates two data blocks that meet a similarity condition in the first data block set; determining an identifier of a target reference data block based on the information about the similarity tree, where a node corresponding to the target reference data block and a node corresponding to the target data block form a parent-child node pair in the plurality of parent-child node pairs, and the node that is in the target parent-child node pair and that corresponds to the target reference data block is a parent node of the node corresponding to the target data block; and obtaining the target reference data block based on the identifier of the target reference data block, and decompressing the first compressed data block based on the target reference data block, to obtain the target data block.

With reference to the second aspect, in some implementations of the second aspect, the information about the similarity tree is stored in any one of the plurality of compressed data blocks.

With reference to the second aspect, in some implementations of the second aspect, the information about the similarity tree includes similar fingerprints of a plurality of data blocks in the first data block set. The plurality of parent-child node pairs in the similarity tree are determined based on the similar fingerprints of the plurality of data blocks in the first data block set. The similarity tree is constructed based on the plurality of parent-child node pairs. An identifier of the parent node that is of the node corresponding to the target data block and that is in the similarity tree is used as the identifier of the target reference data block.

With reference to the second aspect, in some implementations of the second aspect, the information about the similarity tree includes information about the parent-child node pairs in the similarity tree. An identifier that is of the parent node of the node corresponding to the target data block and that is in the information about the parent-child node pairs is used as the identifier of the target reference data block.

With reference to the second aspect, in some implementations of the second aspect, one parent node in the similarity tree includes at least one child node.

With reference to the second aspect, in some implementations of the second aspect, a second compressed data block is obtained from the plurality of compressed data blocks based on the identifier of the target reference data block, where the second compressed data block is obtained by compressing the target reference data block in the first data block set. The second compressed data block is decompressed based on the information about the similarity tree, to obtain the target reference data block.

For beneficial effects of the second aspect, refer to the beneficial effects of the aspects in the first aspect. Details are not described herein again.

According to a third aspect, a data compression apparatus is provided, including an acquisition module, a determining module, and a compression module. The acquisition module is configured to acquire a first data block set, where the first data block set includes a plurality of similar data blocks, and the plurality of data blocks include a target data block. The determining module is configured to determine a target reference data block based on a similarity tree corresponding to the first data block set, where the similarity tree is of a tree structure, the similarity tree includes a plurality of parent-child node pairs, each parent-child node pair indicates two data blocks that meet a similarity condition in the first data block set, the plurality of parent-child node pairs include a target parent-child node pair that indicates the target reference data block and the target data block, and a node that is in the target parent-child node pair and that corresponds to the target reference data block is a parent node of a node corresponding to the target data block. The compression module is configured to perform reference-based compression on the target data block based on the target reference data block, to obtain a target data block after the compression.

With reference to the third aspect, in some implementations of the third aspect, the apparatus further includes a construction module, configured to construct the similarity tree based on respective similar fingerprints of the plurality of data blocks.

With reference to the third aspect, in some implementations of the third aspect, the construction module is specifically configured to: determine the plurality of parent-child node pairs based on the respective similar fingerprints of the plurality of data blocks; and construct the similarity tree based on the plurality of parent-child node pairs.

With reference to the third aspect, in some implementations of the third aspect, the construction module is specifically configured to: select a data block from the first data block set as a root node of the similarity tree, determine a child node corresponding to the root node based on the respective similar fingerprints of the plurality of data blocks and a similarity condition, use the root node and the child node corresponding to the root node as parent nodes, and determine respective similar fingerprints of other data blocks and a similarity condition to determine child nodes corresponding to the parent nodes.

With reference to the third aspect, in some implementations of the third aspect, the construction module is specifically configured to construct the similarity tree corresponding to the first data block set by determining, based on the respective similar fingerprints of the plurality of data blocks in the first data block set, a plurality of parent-child node pairs that meet a condition, and combining the parent-child node pairs.

With reference to the third aspect, in some implementations of the third aspect, the apparatus further includes a storage module, configured to store information about the similarity tree in the data blocks after compression, where the stored information about the similarity tree is used to decompress the plurality of compressed data blocks corresponding to the first data block set.

With reference to the third aspect, in some implementations of the third aspect, the information about the similarity tree includes information about the parent-child node pairs in the similarity tree.

With reference to the third aspect, in some implementations of the third aspect, the information about the similarity tree includes the similar fingerprints of the data blocks in the first data block set.

With reference to the third aspect, in some implementations of the third aspect, the information about the similarity tree is stored in any one of the plurality of compressed data blocks corresponding to the first data block set.

With reference to the third aspect, in some implementations of the third aspect, one parent node in the similarity tree includes at least one child node.

According to a fourth aspect, a data decompression apparatus is provided, including an acquisition module, a determining module, and an obtaining module. The acquisition module is configured to acquire compressed data, where the compressed data includes a plurality of compressed data blocks corresponding to a first data block set and information about a similarity tree corresponding to the first data block set, the plurality of compressed data blocks include a first compressed data block, the first compressed data block is obtained by compressing a target data block in the first data block set, the similarity tree is of a tree structure, the similarity tree includes a plurality of parent-child node pairs, and each parent-child node pair indicates two data blocks that meet a similarity condition in the first data block set. The determining module is configured to determine an identifier of a target reference data block based on the information about the similarity tree, where a node corresponding to the target reference data block and a node corresponding to the target data block form a parent-child node pair in the plurality of parent-child node pairs, and the node that is in the target parent-child node pair and that corresponds to the target reference data block is a parent node of the node corresponding to the target data block. The obtaining module is configured to: obtain the target reference data block based on the identifier of the target reference data block, and decompress the first compressed data block based on the target reference data block, to obtain the target data block.

With reference to the fourth aspect, in some implementations of the fourth aspect, the information about the similarity tree is stored in any one of the plurality of compressed data blocks.

With reference to the fourth aspect, in some implementations of the fourth aspect, the information about the similarity tree includes similar fingerprints of a plurality of data blocks in the first data block set. The determining module is specifically configured to: determine the plurality of parent-child node pairs in the similarity tree based on the similar fingerprints of the plurality of data blocks in the first data block set; construct the similarity tree based on the plurality of parent-child node pairs; and use an identifier of the parent node that is of the node corresponding to the target data block and that is in the similarity tree as the identifier of the target reference data block.

With reference to the fourth aspect, in some implementations of the fourth aspect, the information about the similarity tree includes information about the parent-child node pairs in the similarity tree. The determining module is specifically configured to use an identifier that is of the parent node of the node corresponding to the target data block and that is in the information about the parent-child node pairs as the identifier of the target reference data block.

With reference to the fourth aspect, in some implementations of the fourth aspect, one parent node in the similarity tree includes at least one child node.

With reference to the fourth aspect, in some implementations of the fourth aspect, the obtaining module is specifically configured to: obtain a second compressed data block from the plurality of compressed data blocks based on the identifier of the target reference data block, where the second compressed data block is obtained by compressing the target reference data block in the first data block set; and decompress the second compressed data block based on the information about the similarity tree, to obtain the target reference data block.

According to a fifth aspect, a storage system is provided, including a controller and a storage. The controller is configured to: perform the method according to any one of the first aspect or the possible implementations of the first aspect, and store compressed data in the storage; or the controller is configured to: perform the method according to any one of the second aspect or the possible implementations of the second aspect, and acquire the compressed data from the storage.

According to a sixth aspect, a computing device is provided. The computing device includes a processor and a storage. The processor is configured to execute instructions stored in the storage, to enable the computing device to perform the method according to any one of the first aspect or the possible implementations of the first aspect, or perform the method according to any one of the second aspect and the implementations of the second aspect.

Optionally, the processor may be a general-purpose processor, and may be implemented by hardware or software. When the hardware is used for the implementation, the processor may be a logic circuit, an integrated circuit, or the like. When the software is used for the implementation, the processor may be a general-purpose processor, and is implemented by reading software code stored in the storage. The storage may be integrated into the processor, or may be located outside the processor and exist independently.

For example, the computing device may be a controller in a storage system, or may be a device that has a computing capability and that is connected to the storage system. This is not specifically limited in this application. The device having the computing capability may be an application server connected to the storage system, or may be a third-party computing device connected to the storage system.

According to a seventh aspect, a computer program product including instructions is provided. When the instructions are run by a computing device, the computing device is enabled to perform the method according to any one of the first aspect and the implementations of the first aspect, or perform the method according to any one of the second aspect and the implementations of the second aspect.

According to an eighth aspect, a computer-readable storage medium is provided, including computer program instructions. When the computer program instructions are executed by a computing device, the computing device performs the method according to any one of the first aspect and the implementations of the first aspect, or performs the method according to any one of the second aspect and the implementations of the second aspect.

For example, the computer-readable storage medium includes but is not limited to one or more of the following: a read-only memory (read-only memory, ROM), a programmable ROM (programmable ROM, PROM), an erasable PROM (erasable PROM, EPROM), a flash memory, an electrically EPROM (electrically EPROM, EEPROM), and a hard drive (hard drive).

Optionally, in an implementation, the foregoing storage medium may be specifically a non-volatile storage medium.

### BRIEF DESCRIPTION OF DRAWINGS

FIG. 1 is a diagram of an existing linear relationship between similarities of similar data blocks;
FIG. 2 is a schematic flowchart of a data compression method according to an embodiment of this application;
FIG. 3 is a block diagram of a plurality of data blocks in a first data block set before compression and after compression according to an embodiment of this application;
FIG. 4 is a diagram of a similarity tree corresponding to a first data block set according to an embodiment of this application;
FIG. 5 is a schematic flowchart of a data decompression method according to an embodiment of this application;
FIG. 6 is a schematic flowchart of a method for constructing a similarity tree corresponding to a first data block set according to an embodiment of this application;
FIG. 7 is a block diagram of a process of constructing a similarity tree corresponding to a first data block set according to an embodiment of this application;
FIG. 8 is a schematic flowchart of another method for constructing a similarity tree corresponding to a group of pieces of similar data according to an embodiment of this application;
FIG. 9 is a block diagram of another process of constructing a similarity tree corresponding to a first data block set according to an embodiment of this application;
FIG. 10 is a block diagram of a data compression apparatus 1000 according to an embodiment of this application;
FIG. 11 is a block diagram of a data decompression apparatus 1100 according to an embodiment of this application;
FIG. 12 is a diagram of an architecture of a system according to an embodiment of this application;
FIG. 13 is a diagram of a centralized storage system to which an embodiment of this application is applicable; and
FIG. 14 is a diagram of a distributed storage system according to an embodiment of this application.

### DESCRIPTION OF EMBODIMENTS

The following describes technical solutions in this application with reference to accompanying drawings.

Each aspect, embodiment, or feature is presented in this application with reference to a system including a plurality of devices, components, modules, and the like. It should be appreciated and understood that, each system may include another device, component, module, and the like, and/or may not include all devices, components, modules, and the like discussed with reference to the accompanying drawings. In addition, a combination of these solutions may alternatively be used.

In addition, in embodiments of this application, the terms such as "example" or "for example" are for representing giving an example, an illustration, or a description. Any embodiment or design scheme described as an "example" in this application should not be explained as being more preferred or having more advantages than another embodiment or design scheme. Exactly, the term "example" is for presenting a concept in a specific manner.

In embodiments of this application, "relevant (corresponding, relevant)" and "corresponding (corresponding)" may be interchangeably used sometimes. It should be noted that meanings expressed by the terms are consistent when a difference between them is not emphasized.

A service scenario described in embodiments of this application is intended to describe the technical solutions in embodiments of this application more clearly, and does not constitute a limitation on the technical solutions provided in embodiments of this application. A person of ordinary skill in the art may learn that, with evolution of network architectures and emergence of new service scenarios, the technical solutions provided in embodiments of this application are also applicable to a similar technical problem.

Reference to "an embodiment", "some embodiments", or the like described in this specification means that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and variants thereof all mean "include but are not limited to", unless otherwise specifically emphasized in another manner.

In this application, "at least one" means one or more, and "a plurality of" means two or more. The term "and/or" describes an association relationship for describing associated objects and represents that three relationships may exist. For example, A and/or B may represent the following cases: Only A exists, both A and B exist, and only B exists, where A and B may be singular or plural. The character "/" generally represents an "or" relationship between the associated objects. "At least one item (piece) of the following" or a similar expression thereof means any combination of these items, including a singular item (piece) or any combination of plural items (pieces). For example, at least one item (piece) of a, b, or c may represent: a, b, c, a and b, a and c, b and c, or a, b, and c, where a, b, and c may be singular or plural.

For ease of description, the following first describes in detail basic concepts in embodiments of this application.

### 1. Data compression (data compression)

The data compression is a process of encoding original data with less space. This means that an amount of data is reduced, without losing useful information, to reduce storage space, and improve transmission, storage, and processing efficiency. Alternatively, the data compression is a compression technology method in which data is reorganized according to a specific algorithm, to reduce data redundancy and storage space.

Compression technologies may be classified into lossless compression and lossy compression. The lossless compression means that data after compression is used for decompression, and obtained data is completely the same as the original data. The lossy compression means that data after compression is used for decompression, and obtained data is different from the original data. The lossy compression is mainly applicable to the image or video compression field.

### 2. Compression rate (Compression rate, CR)

The compression rate is a percentage of a size of a file after compression to a size of a file before the compression. For example, if a file of 100 M is compressed into a file of 90 M, a compression rate is 90/100*100%=90%. Generally, a smaller compression rate indicates better performance but longer decompression time.

### 3. Deduplication (deduplication)

The deduplication is an implementation of data compression. The foregoing conventional compression technology can only eliminate redundant information in a file. A deduplication technology can effectively reduce physical storage space occupied by data by eliminating same files or data blocks in a distributed storage system. This technology is widely applied to storage backup and archiving systems.

### 4. Similarity-based compression

The similarity-based compression is another implementation of data compression. Compared with a deduplication technology that has a constraint that requires data blocks to be exactly the same to eliminate redundant data, a similarity-based deduplication technology has a significant reduction effect for data blocks that are incompletely identical but have a specific degree of similarity. Specifically, a reference data block is determined from a plurality of similar data blocks, and reference-based compression is performed on a to-be-compressed data block based on the reference data block.

With continuous improvement of informatization and rapid development of big data, cloud computing, and artificial intelligence technologies, a demand of an enterprise for data increases explosively. Such a large amount of data inevitably brings great pressure to data storage management. Therefore, data reduction or compression is a key technology in storage systems to improve storage space utilization and meet rapidly growing storage requirements with a limited storage capacity.

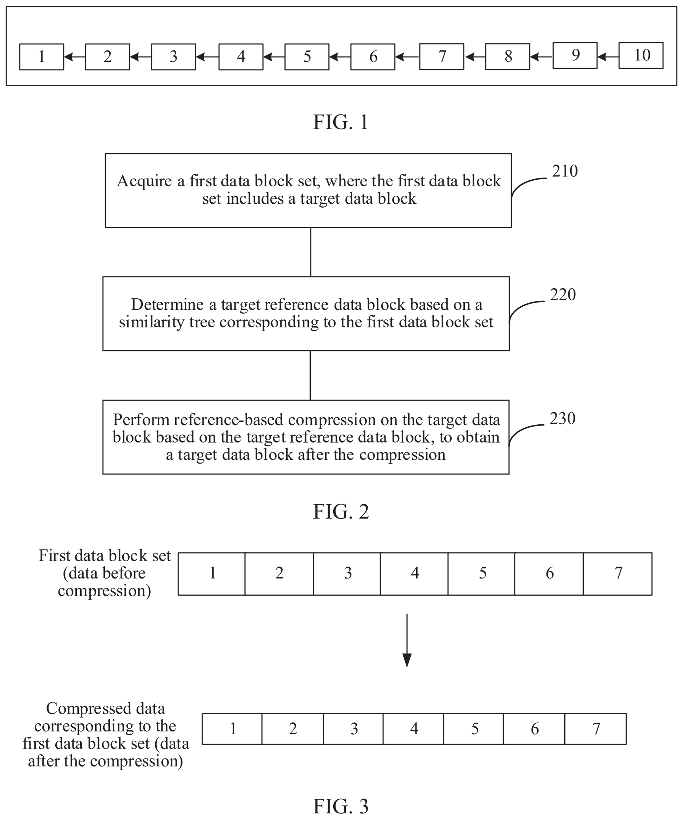

In a related technical solution, when the similarity-based compression is performed, as shown in FIG. 1, similarities between similar data blocks exhibit a linear relationship. To be specific, in a process of performing reference-based compression on data blocks, one data block is compressed based on all data blocks previous to the data block. This means that, in a process of decompressing data blocks, decompressing one of the data blocks depends on all previous data blocks. In this case, decompression resource overheads are increased. For example, as shown in FIG. 1, decompressing a data block 10 is used as an example. To decompress the data block 10, a data block 1 to a data block 9 all need to be decompressed. However, the data block 10 is most similar to the data block 9, and a similarity benefit mainly comes from the data block 9. In this case, when the data block 10 is decompressed, dependence on all the previous data blocks causes a waste of a large quantity of computing resources.

In view of this, an embodiment of this application provides a data compression method, to reduce resource overheads when compressed data is decompressed, and avoid a waste of a large quantity of computing resources.

FIG. 2 is a schematic flowchart of a data compression method according to an embodiment of this application. As shown in FIG. 2, the method may include steps 210 to 230. The following separately describes steps 210 to 230 in detail.

Step 210: Acquire a first data block set, where the first data block set includes a target data block.

In this embodiment of this application, a group of similar data blocks may be determined based on a similarity between the data blocks, and the group of data blocks forms the first data block set. The first data block set includes a plurality of similar data blocks. For example, the plurality of data blocks include the target data block.

There are a plurality of methods for determining the group of similar data blocks. This is not specifically limited in embodiments of this application. In an example, the group of similar data blocks may be determined based on respective similar fingerprints of the plurality of data blocks.

It should be understood that the data block may be a file, or may be a combination of file slices. This is not specifically limited in embodiments of this application.

For example, as shown in FIG. 3, a data block 1 to a data block 7 are determined as a group of similar data blocks based on similar fingerprints of the data blocks. That is, the first data block set includes the data block 1 to the data block 7.

Step 220: Determine a target reference data block based on a similarity tree corresponding to the first data block set.

Optionally, before step 220, in this embodiment of this application, the similarity tree corresponding to the first data block set may be constructed. Specifically, a plurality of parent-child node pairs may be determined based on the respective similar fingerprints of the plurality of data blocks included in the first data block set, and the foregoing similarity tree is constructed based on the plurality of parent-child node pairs. The following describes in detail two possible implementations of constructing the similarity tree.

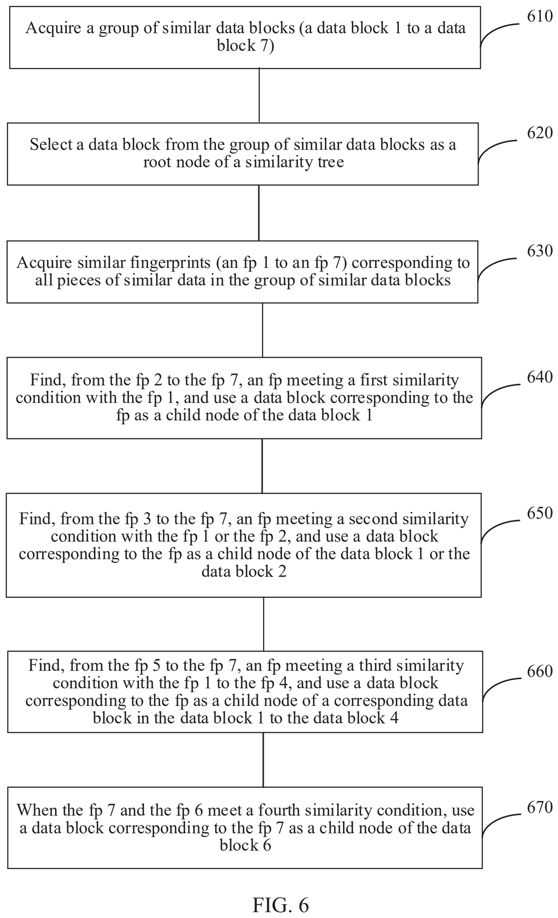

In a possible implementation, a data block may be selected from the first data block set as a root node of the similarity tree, a child node corresponding to the root node is determined based on the respective similar fingerprints of the plurality of data blocks and a similarity condition, the root node and the child node corresponding to the root node are then used as parent nodes, child nodes corresponding to the parent nodes are determined based on respective similar fingerprints of other data blocks and a similarity condition, and the rest can be deduced by analogy, until the similarity tree corresponding to the first data block set is constructed. The following describes this implementation in detail with reference to FIG. 6, and details are not described herein temporarily.

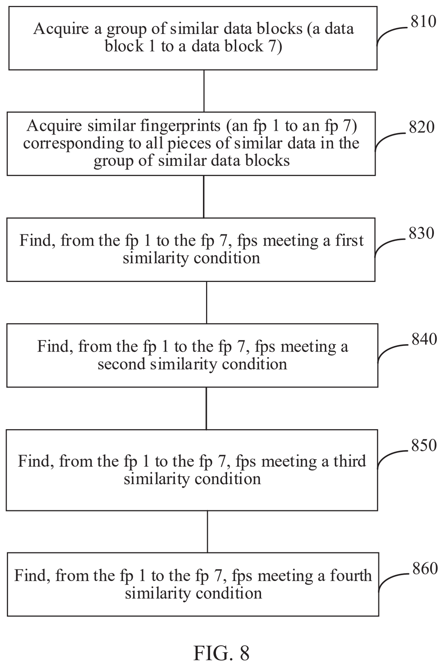

In another possible implementation, a data block may not be selected as a root node of the similarity tree, but the similarity tree corresponding to the first data block set may be constructed by determining, based on the respective similar fingerprints of the plurality of data blocks in the first data block set, the plurality of parent-child node pairs that meet a condition, and combining the parent-child node pairs. The following describes this implementation in detail with reference to FIG. 8, and details are not described herein temporarily.

In this embodiment of this application, the similarity tree corresponding to the first data block set is of a tree structure, the similarity tree includes the plurality of parent-child node pairs, and each parent-child node pair indicates two data blocks that meet a similarity condition in the first data block set. In an example, one parent node pair in the similarity tree includes at least one child node.

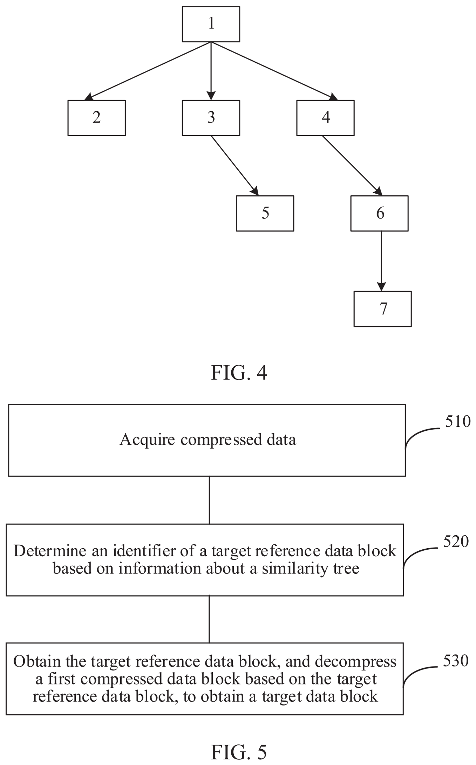

For example, FIG. 4 shows a constructed similarity tree. The similarity tree represents, in a tree form, similarities between the data block 1 to the data block 7 shown in FIG. 3. The similarity tree includes a plurality of parent-child node pairs, and two nodes that have a parent-child relationship in the similarity tree form each parent-child node pair. For example, the data block 1 and the data block 2 are a parent-child node pair, the data block 1 is a parent node of the data block 2, and the data block 2 is a child node of the data block 1.

The following should be noted: The data block 1 is used as an example. The data block 1, as the parent node, may include at least one child node. In FIG. 4, an example in which the data block 1 includes one child node is used for description. The data block 1 may further include another child node. This is not specifically limited in embodiments of this application.

In this embodiment of this application, the target reference data block may be determined based on the similarity tree corresponding to the first data block set. Specifically, the similarity tree corresponding to the first data block set may include the plurality of parent-child node pairs, and the plurality of parent-child node pairs include a target parent-child node pair that indicates the target reference data block and the target data block. Because a node corresponding to the target reference data block in the target parent-child node pair is a parent node of a node corresponding to the target data block, the target reference data block may be used as a reference data block used when data compression is performed on the target data block.

The similarity tree shown in FIG. 4 is used as an example. It is assumed that the data block 2 is the target data block. Because a node corresponding to the data block 1 is a parent node of a node corresponding to the data block 2, the data block 2 may be used as a target reference data block of the data block 1.

Step 230: Perform reference-based compression on the target data block based on the target reference data block, to obtain a target data block after the compression.

In this embodiment of this application, similarity-based compression (which may also be referred to as the reference-based compression) may be performed on the target data block based on the determined target reference data block, to obtain the target data block after the compression. For a specific similarity-based compression process, refer to the foregoing descriptions. Details are not described herein again.

The following describes, by using the first data block set in FIG. 3 as an example, based on the similarity tree that corresponds to the first data block set and that is in FIG. 4, a process of performing similarity-based compression on the data blocks included in the first data block set.

As shown in FIG. 3, because the data block 1 is a root node, self-compression may be performed on the data block 1, that is, similarity-based compression is performed inside the data block 1. The parent node of the data block 2 is the data block 1. Therefore, a reference data block of the data block 2 is the data block 1. Reference-based compression may be performed on the data block 2 based on the data block 1, in other words, information that is in the data block 2 and that is the same as that in the data block 1 may be deleted, to implement similarity-based compression. A parent node of the data block 3 is the data block 1. Therefore, a reference data block of the data block 3 is the data block 1. Reference-based compression may be performed on the data block 3 based on the data block 1, in other words, information that is in the data block 3 and that is the same as that in the data block 1 may be deleted, to implement similarity-based compression. A parent node of the data block 4 is the data block 1. Therefore, a reference data block of the data block 4 is the data block 1. Reference-based compression may be performed on the data block 4 based on the data block 1, in other words, information that is in the data block 4 and that is the same as that in the data block 1 may be deleted, to implement similarity-based compression. Parent nodes of the data block 5 are the data block 3 and the data block 1. Therefore, reference data blocks of the data block 5 are the data block 3 and the data block 1. Reference-based compression may be performed on the data block 5 based on the data block 3 and the data block 1, in other words, information that is in the data block 5 and that is the same as those in the data block 3 and the data block 1 may be deleted, to implement similarity-based compression. Parent nodes of the data block 6 are the data block 4 and the data block 1. Therefore, reference data blocks of the data block 6 are the data block 4 and the data block 1. Reference-based compression may be performed on the data block 6 based on the data block 4 and the data block 1, in other words, information that is in the data block 6 and that is the same as those in the data block 4 and the data block 1 may be deleted, to implement similarity-based compression. Parent nodes of the data block 7 are the data block 6, the data block 4, and the data block 1. Therefore, reference data blocks of the data block 7 are the data block 6, the data block 4, and the data block 1. Reference-based compression may be performed on the data block 7 based on the data block 6, the data block 4, and the data block 1, in other words, information that is in the data block 7 and that is the same as those in the data block 6, the data block 4, and the data block 1 may be deleted, to implement similarity-based compression.

In this embodiment of this application, after data compression is performed on the data blocks in the first data set, information about the similarity tree corresponding to the first data set may be further stored, so that when a plurality of pieces of compressed data corresponding to the first data set are decompressed, reference data blocks corresponding to the compressed data blocks may be determined by using the stored information about the similarity tree, and the compressed data blocks are decompressed based on the determined reference data blocks.

There are a plurality of implementations of the information about the similarity tree. This is not specifically limited in embodiments of this application. In a possible implementation, the information about the similarity tree includes information about the parent-child node pairs in the similarity tree. In another possible implementation, the information about the similarity tree includes the similar fingerprints of the data blocks in the first data set.

The following describes in detail a manner of storing the information about the similarity tree.

In a possible implementation, for example, the information about the similarity tree includes the information about the parent-child node pairs in the similarity tree. In an example, the information about all the parent-child node pairs in the similarity tree may be stored in any one of the plurality of pieces of compressed data corresponding to the first data set. For example, the information about all the parent-child node pairs is stored in a data block that is after compression and that corresponds to the root node of the similarity tree. In another example, parent node information of each data block after compression may alternatively be stored in the data block. In another example, information that is about the similarity tree and that is needed for decompressing each data block after compression may alternatively be stored in the data block.

The similarity tree shown in FIG. 4 is used as an example. In an example, the information about all the parent-child node pairs is stored in the data block that is after the compression and that corresponds to the root node of the similarity tree. For example, the information that is about the parent-child node pairs and that is stored in a data block 1 that is after compression and that corresponds to the root node includes 2, 1; 3, 1; 4, 1; 5, 3; 6, 4; and 7, 6. In another example, the parent node information of each data block after the compression is stored in the data block. For example, parent-child node pair information stored in a data block 2 after compression is "2, 1", parent-child node pair information stored in a data block 3 after compression is "3, 1", parent-child node pair information stored in a data block 4 after compression is "4, 1", parent-child node pair information stored in a data block 5 after compression is "5, 3", parent-child node pair information stored in a data block 6 after compression is "6, 4", and parent-child node pair information stored in a data block 7 after compression is "7, 6". In another example, information that is about the similarity tree and that is needed for decompressing a data block after compression may alternatively be stored in the data block. In another example, the information that is about the similarity tree and that is needed for decompressing each data block after the compression is stored in the data block. For example, parent-child node pair information stored in a data block 2 after compression is "2, 1", parent-child node pair information stored in a data block 3 after compression is "3, 1", parent-child node pair information stored in a data block 4 after compression is "4, 1", parent-child node pair information stored in a data block 5 after compression is "5, 3" and "3, 1", parent-child node pair information stored in a data block 6 after compression is "6, 4" and "4, 1", and parent-child node pair information stored in a data block 7 after compression is "7, 6", "6, 4", and "4, 1".

"2, 1" represents that the data block 2 is the child node of the data block 1, "3, 1" represents that the data block 3 is a child node of the data block 1, "4, 1" represents that the data block 3 is a child node of the data block 1, "5, 3" represents that the data block 5 is a child node of the data block 3, "6, 4" represents that the data block 6 is a child node of the data block 4, and "7, 6" represents that the data block 7 is a child node of the data block 6.

In another possible implementation, an example in which the information about the similarity tree includes the similar fingerprints of the data blocks in the first data set is used. In an example, the similar fingerprints of all the data blocks in the first data set may be stored in any one of the plurality of pieces of compressed data corresponding to the first data set. For example, the similar fingerprints of all the data blocks in the first data set may be stored in a data block that is after compression and that corresponds to the root node of the similarity tree. The similarity tree shown in FIG. 4 is used as an example, the similar fingerprints of all the data blocks include similar fingerprints of the data block 1 to the data block 7. In another example, similar fingerprints of parts of data blocks in the first data set may alternatively be stored in data blocks after compression, and a sum of the similar fingerprints of the parts of data blocks is the similar fingerprints of all the data blocks in the first data set. For example, a similar fingerprint of the data block 1 is stored in a data block 1 after compression, similar fingerprints of the data block 2 to the data block 4 are stored in a data block 2 after compression, and similar fingerprints of the data block 5 to the data block 7 are stored in a data block 3 after compression.

In the foregoing technical solution, the similarity-based compression is performed on the target data block based on the target reference data block determined based on the similarity tree of the tree structure. In the similarity tree, the node corresponding to the target reference data block is the parent node of the node of the target data block. Because the target data block is compressed based on the target reference data block, and the node corresponding to the target data block and the node corresponding to the target reference data block have a parent-child relationship in the similarity tree, during decompression of the data blocks, decompression of one of the data blocks depends only on a data block on a path of the root node, and depends on none of previous data blocks in a linear relationship. Therefore, during the decompression, resource overheads can be reduced, a waste of a large quantity of computing resources can be avoided, and performance can be improved while a compression rate is ensured.

FIG. 5 is a schematic flowchart of a data decompression method according to an embodiment of this application. As shown in FIG. 5, the method may include steps 510 to 530. The following separately describes steps 510 to 530 in detail.

Step 510: Acquire compressed data.

In this embodiment of this application, the acquired compressed data may include a plurality of compressed data blocks corresponding to a first data block set and information about a similarity tree corresponding to the first data block set. The plurality of compressed data blocks include a first compressed data block, the first compressed data block is obtained by compressing a target data block in the first data block set, the similarity tree is of a tree structure, the similarity tree includes a plurality of parent-child node pairs, and each parent-child node pair indicates two data blocks that meet a similarity condition in the first data block set.

It should be understood that, in embodiments of this application, data compression may be separately performed on a plurality of data blocks included in the first data block set, to obtain a plurality of compressed data blocks. The plurality of compressed data blocks may be referred to as the plurality of compressed data blocks corresponding to the first data block set.

The acquired information about the similarity tree corresponding to the first data block set may be similar fingerprints of the plurality of data blocks in the first data block set, or may be information about the parent-child node pairs in the similarity tree. This is not limited in embodiments of this application. The information about the similarity tree may be acquired from one piece of compressed data. Alternatively, parts of information about the similarity tree may be respectively acquired from the plurality of pieces of compressed data. This is specifically related to a manner of storing the information about the similarity tree. For the manner of storing the information about the similarity tree, refer to the foregoing descriptions. Details are not described herein again.

Step 520: Determine an identifier of a target reference data block based on the information about the similarity tree.

In this embodiment of this application, after the information about the similarity tree corresponding to the first data block set is acquired, the identifier of the target reference data block may be determined based on the information about the similarity tree. The following describes in detail two specific implementations of determining the identifier of the target reference data block.

In a possible implementation, the acquired information about the similarity tree includes the similar fingerprints of the plurality of data blocks in the first data block set. In this implementation, the plurality of parent-child node pairs in the similarity tree may be determined based on the similar fingerprints of the plurality of data blocks, and the similarity tree is constructed based on the plurality of parent-child node pairs. A node corresponding to the target reference data block and a node corresponding to the target data block form a parent-child node pair in the plurality of parent-child node pairs in the similarity tree, and the node that is in the target parent-child node pair and that corresponds to the target reference data block is a parent node of the node corresponding to the target data block. Therefore, an identifier of the parent node that is of the node corresponding to the target data block and that is in the similarity tree may be used as the identifier of the target reference data block.

In another possible implementation, the acquired information about the similarity tree includes the information about the parent-child node pairs in the similarity tree. In this implementation, in the information about the parent-child node pairs, an identifier of a parent node of a node corresponding to the target data block may be used as the identifier of the target reference data block.

For example, the target data block is a data block 5, and the first compressed data block is obtained by compressing the data block 5. It may be determined, based on the foregoing information (5, 3) about the similarity tree, that a node corresponding to a data block 3 is a parent node of a node corresponding to the data block 5. Therefore, the data block 3 (a data block before compression) may be used as the target reference data block to decompress the first compressed data block, to obtain the data block 5.

Step 530: Obtain the target reference data block, and decompress the first compressed data block based on the target reference data block, to obtain the target data block.

In this embodiment of this application, after the target reference data block is obtained based on the identifier of the target reference data block, the first compressed data block may be decompressed based on the target reference data block, to obtain the target data block.

For example, second compressed data may be acquired from the plurality of pieces of compressed data based on the identifier of the target reference data block. The second compressed data is obtained by compressing the target reference data block in the first data set. Then, the second compressed data block is decompressed based on the information about the similarity tree, to obtain the target reference data block. A method for decompressing the second compressed data block is the same as a method for decompressing the first compressed data block. Specifically, for example, a reference data block used when the target reference data block is compressed to obtain the second compressed data block may be determined based on the information about the similarity tree, and the second compressed data block is decompressed based on the reference data block, to obtain the target reference data block.

For example, the second compressed data block is obtained by compressing the data block 3. It may be determined, based on information (3, 1) about the similarity tree, that a node corresponding to a data block 1 is a parent node of the node corresponding to the data block 3. Therefore, the data block 1 (a data block before compression) may be used as the target reference data block to decompress the second compressed data block, to obtain the data block 3. Similarly, a third compressed data block may be acquired from a plurality of target reference data blocks. The compressed data block is obtained by compressing the data block 1. It may be determined, based on information about the similarity tree in FIG. 4, that the data block 1 is a root node of the similarity tree, and self-compression is performed on the data block 1. Therefore, after the third compressed data block is decompressed, the data block 1 (a data block before compression) is obtained.

With reference to FIG. 6 to FIG. 9, the following describes in detail different implementations of how to construct the similarity tree shown in FIG. 4. It should be understood that examples in FIG. 6 to FIG. 9 are merely intended to help a person skilled in the art understand embodiments of this application, but are not intended to limit embodiments of this application to specific values or specific scenarios in the examples in FIG. 6 to FIG. 9. It is clear that the person skilled in the art can make various equivalent modifications or changes based on the following examples provided in FIG. 6 to FIG. 9, and such modifications and changes also fall within the scope of embodiments of this application.

FIG. 6 is a schematic flowchart of a method for constructing a similarity tree corresponding to a first data block set according to an embodiment of this application. As shown in FIG. 6, the method may include steps 610 to 670. The following separately describes steps 610 to 670 in detail.

Step 610: Acquire a group of similar data blocks (a data block 1 to a data block 7).

For example, as shown in FIG. 3, the group of similar data blocks includes the data block 1 to the data block 7.

Step 620: Select a data block from the group of similar data blocks as a root node of the similarity tree.

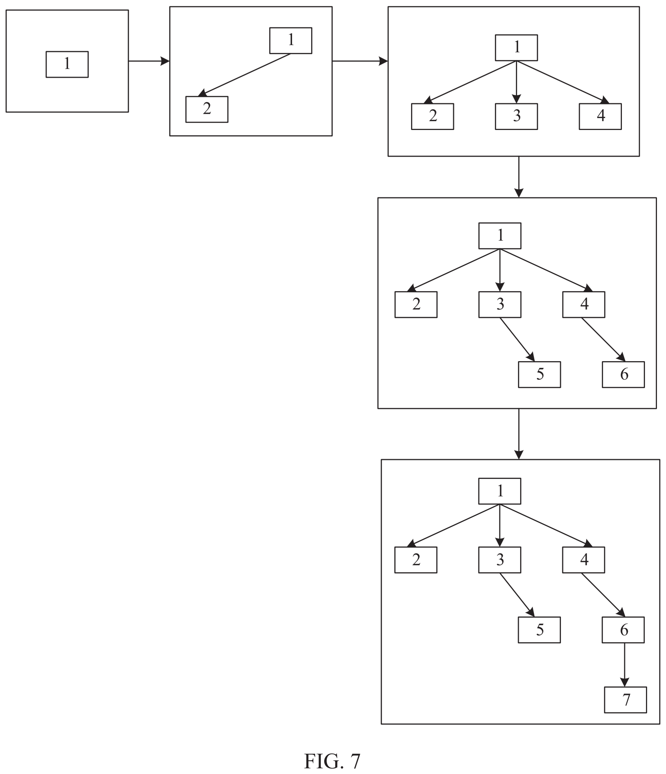

In this embodiment of this application, a data block may be randomly selected from the group of similar data blocks as the root node of the similarity tree. For ease of description, as shown in FIG. 7, the data block 1 is used as the root node of the similarity tree.

Step 630: Acquire similar fingerprints (an fp 1 to an fp 7) corresponding to all pieces of similar data in the group of similar data blocks.

In this embodiment of this application, after the group of pieces of similar data is determined, the similar fingerprints corresponding to the pieces of similar data may be acquired. For example, the group of similar data blocks includes the data block 1 to the data block 7. The acquired similar fingerprints may include the fp 1 to the fp 7, where the fp 1 represents a similar fingerprint corresponding to the data block 1, the fp 2 represents a similar fingerprint corresponding to the data block 2, and the rest can be deduced by analogy.

Step 640: Find, from the fp 2 to the fp 7, an fp meeting a first similarity condition with the fp 1, and use a data block corresponding to the fp as a child node of the data block 1.

For example, in this embodiment of this application, the first similarity condition may be set, the fp meeting the first similarity condition with the fp 1 is found from the fp 2 to the fp 7, and the data block corresponding to the fp is used as the child node of the data block 1.

For example, because the fp is a 4-bit value, it is assumed that the first similarity condition is that four bits are all the same as those of the fp 1, in other words, an fp that is in the fp 2 to the fp 7 and that has the same four bits as those of the fp 1 may be referred to as the fp meeting the first similarity condition. For example, as shown in FIG. 7, it is assumed that four bits of the fp 2 are the same as those of the fp 1. Therefore, the data block 2 corresponding to the fp 2 may be used as a child node of the data block 1.

Step 650: Find, from the fp 3 to the fp 7, an fp meeting a second similarity condition with the fp 1 or the fp 2, and use a data block corresponding to the fp as a child node of the data block 1 or the data block 2.

For example, in this embodiment of this application, the second similarity condition may be set, the fp meeting the second similarity condition with the fp 1 or the fp 2 is found from the fp 3 to the fp 7, and the data block corresponding to the fp is used as the child node of the data block 1 or the data block 2.

For example, it is assumed that the second similarity condition is that three bits are the same as those of the fp 1 or the fp 2, in other words, an fp that is in the fp 3 to the fp 7 and that has the same three bits as those of the fp 1 or the fp 2 may be referred to as the fp meeting the second similarity condition. For example, as shown in FIG. 7, three bits of the fp 3 are the same as those of the fp 1, and three bits of the fp 4 are the same as those of the fp 1. Therefore, the data block 3 corresponding to the fp 3 may be used as a child node of the data block 1, and similarly, the data block 4 corresponding to the fp 4 is also used as a child node of the data block 1.

Step 660: Find, from the fp 5 to the fp 7, an fp meeting a third similarity condition with the fp 1 to the fp 4, and use a data block corresponding to the fp as a child node of a corresponding data block in the data block 1 to the data block 4.

For example, in this embodiment of this application, the third similarity condition may be set, the fp meeting the third similarity condition with the fp 1 to the fp 4 is found from the fp 5 to the fp 7, and the data block corresponding to the fp is used as the child node of the corresponding data block in the data block 1 to the data block 4.

For example, it is assumed that the third similarity condition is that two bits are the same as those of the fp 1 to the fp 4, in other words, an fp that is in the fp 5 to the fp 7 and that has the same two bits as those of any one of the fp 1 to the fp 4 may be referred to as the fp meeting the second similarity condition. For example, as shown in FIG. 7, two bits of the fp 5 are the same as those of the fp 3, and two bits of the fp 6 are the same as those of the fp 4. Therefore, the data block 5 corresponding to the fp 5 may be used as a child node of the data block 3, and similarly, the data block 6 corresponding to the fp 6 is also used as a child node of the data block 4.

Step 670: When the fp 7 and the fp 6 meet a fourth similarity condition, use a data block corresponding to the fp 7 as a child node of the data block 6.

For example, it is assumed that the third similarity condition is that one bit is the same as that of the fp 1 to the fp 6. For example, as shown in FIG. 7, one bit of the fp 7 is the same as that of the fp 6. Therefore, the data block 7 corresponding to the fp 7 may be used as a child node of the data block 6.

In this embodiment of this application, the similarity tree shown in FIG. 4 may be constructed by using the method in FIG. 6.

FIG. 8 is a schematic flowchart of another method for constructing a similarity tree corresponding to a group of pieces of similar data according to an embodiment of this application. As shown in FIG. 8, the method may include steps 810 to 860. The following separately describes steps 810 to 860 in detail.

Step 810: Acquire the group of similar data blocks (a data block 1 to a data block 7).

This step is similar to step 610. For details, refer to the descriptions of step 610. Details are not described herein again.

Step 820: Acquire similar fingerprints (an fp 1 to an fp 7) corresponding to all pieces of similar data in the group of similar data blocks.

This step is similar to step 630. For details, refer to the descriptions of step 630. Details are not described herein again.

Step 830: Find, from the fp 1 to the fp 7, fps meeting a first similarity condition.

In this embodiment of this application, it is assumed that the first similarity condition is that four bits of two or more fps are the same, for example, four bits of two or more specific fps in the fp 1 to the fp 7 are the same. In this case, the two or more fps may be referred to as the fps meeting the first similarity condition.

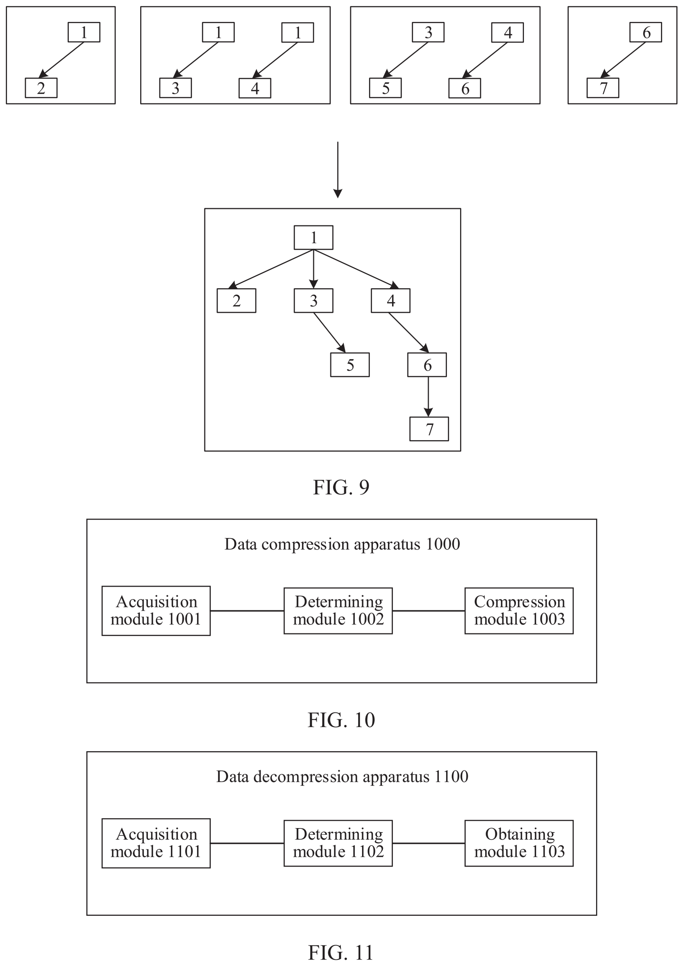

For example, as shown in FIG. 9, it is assumed that four bits of the fp 1 are the same as those of the fp 2. Therefore, the fp 1 and the fp 2 meet the first similarity condition, and the data block 2 corresponding to the fp 2 may be used as a child node of the data block 1 corresponding to the fp 1.

Step 840: Find, from the fp 1 to the fp 7, fps meeting a second similarity condition.

In this embodiment of this application, it is assumed that the second similarity condition is that three bits of two or more fps are the same, for example, three bits of two or more specific fps in the fp 1 to the fp 7 are the same. In this case, the two or more fps may be referred to as the fps meeting the second similarity condition.

For example, as shown in FIG. 9, it is assumed that three bits of the fp 1 are the same as those of the fp 3, and three bits of the fp 1 are the same as those of the fp 4. Therefore, the fp 1 and the fp 3 meet the second similarity condition, and the fp 1 and the fp 4 also meet the second similarity condition. The data block 3 corresponding to the fp 3 may be used as a child node of the data block 1 corresponding to the fp 1, and the data block 4 corresponding to the fp 4 may be used as a child node of the data block 1 corresponding to the fp 1.

Step 850: Find, from the fp 1 to the fp 7, fps meeting a third similarity condition.

In this embodiment of this application, it is assumed that the third similarity condition is that two bits of two or more fps are the same, for example, two bits of two or more specific fps in the fp 1 to the fp 7 are the same. In this case, the two or more fps may be referred to as the fps meeting the third similarity condition.

For example, as shown in FIG. 9, it is assumed that two bits of the fp 3 are the same as those of the fp 5, and two bits of the fp 4 are the same as those of the fp 6. Therefore, the fp 3 and the fp 5 meet the third similarity condition, and the fp 4 and the fp 6 also meet the third similarity condition. The data block 5 corresponding to the fp 5 may be used as a child node of the data block 3 corresponding to the fp 3, and the data block 6 corresponding to the fp 6 may be used as a child node of the data block 1 corresponding to the fp 4.

Step 860: Find, from the fp 1 to the fp 7, fps meeting a fourth similarity condition.

In this embodiment of this application, it is assumed that the fourth similarity condition is that one bit of two or more fps is the same, for example, one bit of two or more specific fps in the fp 1 to the fp 7 is the same. In this case, the two or more fps may be referred to as the fps meeting the fourth similarity condition.

For example, as shown in FIG. 9, it is assumed that one bit of the fp 6 is the same as that of the fp 7. Therefore, the fp 6 and the fp 7 meet the fourth similarity condition. The data block 7 corresponding to the fp 7 may be used as a child node of the data block 6 corresponding to the fp 6.

In this embodiment of this application, by using the method in FIG. 8, the fps meeting the first similarity condition, the fps meeting the second similarity condition, the fps meeting the third similarity condition, and the fps meeting the fourth similarity condition are combined, so that the similarity tree shown in FIG. 4 can also be constructed.

It should be noted that an application scenario of constructing the similarity tree shown in FIG. 6 or FIG. 8 is not specifically limited in embodiments of this application. In an example, the method for constructing the similarity tree may be applied to the foregoing data compression field. In another example, the method for constructing the similarity tree may alternatively be applied to another data processing field associated with similarity-based grouping.

The foregoing describes in detail the data compression method and the data decompression method provided in embodiments of this application with reference to FIG. 1 to FIG. 9. The following describes in detail apparatus embodiments of this application with reference to FIG. 10 to FIG. 14. It should be understood that, descriptions of the method embodiments correspond to descriptions of the apparatus embodiments. Therefore, for a part not described in detail, refer to the foregoing method embodiments.

FIG. 10 is a block diagram of a data compression apparatus 1000 according to an embodiment of this application. The apparatus 1000 may be implemented by software, hardware, or a combination of software and hardware. The apparatus 1000 provided in this embodiment of this application may implement a data compression method procedure provided in embodiments of this application. The apparatus 1000 includes an acquisition module 1001, a determining module 1002, and a compression module 1003. The acquisition module 1001 is configured to acquire a first data block set, where the first data block set includes a plurality of similar data blocks, and the plurality of data blocks include a target data block. The determining module 102 is configured to determine a target reference data block based on a similarity tree corresponding to the first data block set, where the similarity tree is of a tree structure, the similarity tree includes a plurality of parent-child node pairs, each parent-child node pair indicates two data blocks that meet a similarity condition in the first data block set, the plurality of parent-child node pairs include a target parent-child node pair that indicates the target reference data block and the target data block, and a node that is in the target parent-child node pair and that corresponds to the target reference data block is a parent node of a node corresponding to the target data block. The compression module 1003 is configured to perform reference-based compression on the target data block based on the target reference data block, to obtain a target data block after the compression.

Optionally, the apparatus 1000 further includes a construction module, configured to construct the similarity tree based on respective similar fingerprints of the plurality of data blocks.

Optionally, the construction module is specifically configured to: determine the plurality of parent-child node pairs based on the respective similar fingerprints of the plurality of data blocks; and construct the similarity tree based on the plurality of parent-child node pairs.

Optionally, the construction module is specifically configured to: select a data block from the first data block set as a root node of the similarity tree, determine a child node corresponding to the root node based on the respective similar fingerprints of the plurality of data blocks and a similarity condition, use the root node and the child node corresponding to the root node as parent nodes, and determine respective similar fingerprints of other data blocks and a similarity condition to determine child nodes corresponding to the parent nodes.

Optionally, the construction module is specifically configured to construct the similarity tree corresponding to the first data block set by determining, based on the respective similar fingerprints of the plurality of data blocks in the first data block set, a plurality of parent-child node pairs that meet a condition, and combining the parent-child node pairs.

Optionally, the apparatus 1000 further includes a storage module, configured to store information about the similarity tree in the data blocks after compression, where the stored information about the similarity tree is used to decompress the plurality of compressed data blocks corresponding to the first data block set.

Optionally, the information about the similarity tree includes information about the parent-child node pairs in the similarity tree.

Optionally, the information about the similarity tree includes the similar fingerprints of the data blocks in the first data block set.

Optionally, the information about the similarity tree is stored in any one of the plurality of compressed data blocks corresponding to the first data block set.

Optionally, one parent node in the similarity tree includes at least one child node.

The apparatus 1000 may be implemented in a form of a functional module. The term "module" herein may be implemented in a form of software and/or hardware, and this is not specifically limited.

It should be noted that when the apparatus 1000 provided in the foregoing embodiment performs the foregoing method, division into the foregoing functional modules is merely used as an example for description. During actual application, the foregoing functions may be allocated to different functional modules and implemented based on a requirement, that is, an internal structure of the apparatus is divided into different functional modules to implement all or some of the functions described above. For example, the acquisition module 1001 may be configured to perform any step in the foregoing method, the determining module 1002 may be configured to perform any step in the foregoing method, and the compression module 1003 may be configured to perform any step in the foregoing method. Steps that the acquisition module 1001, the determining module 1002, and the compression module 1003 are responsible for implementing may be specified based on a requirement. The acquisition module 1001, the determining module 1002, and the compression module 1003 separately implement different steps in the foregoing method to implement all functions of the foregoing apparatus.

FIG. 11 is a block diagram of a data decompression apparatus 1100 according to an embodiment of this application. The apparatus 1100 may be implemented by software, hardware, or a combination of software and hardware. The apparatus 1100 provided in this embodiment of this application may implement a data decompression method procedure provided in embodiments of this application. The apparatus 1100 includes an acquisition module 1101, a determining module 1102, and an obtaining module 1103. The acquisition module 1101 is configured to acquire compressed data, where the compressed data includes a plurality of compressed data blocks corresponding to a first data block set and information about a similarity tree corresponding to the first data block set, the plurality of compressed data blocks include a first compressed data block, the first compressed data block is obtained by compressing a target data block in the first data block set, the similarity tree is of a tree structure, the similarity tree includes a plurality of parent-child node pairs, and each parent-child node pair indicates two data blocks that meet a similarity condition in the first data block set. The determining module 1102 is configured to determine an identifier of a target reference data block based on the information about the similarity tree, where a node corresponding to the target reference data block and a node corresponding to the target data block form a parent-child node pair in the plurality of parent-child node pairs, and the node that is in the target parent-child node pair and that corresponds to the target reference data block is a parent node of the node corresponding to the target data block. The obtaining module 1103 is configured to: obtain the target reference data block based on the identifier of the target reference data block, and decompress the first compressed data block based on the target reference data block, to obtain the target data block.

Optionally, the information about the similarity tree is stored in any one of the plurality of compressed data blocks.

Optionally, the information about the similarity tree includes similar fingerprints of a plurality of data blocks in the first data block set. The determining module 1102 is specifically configured to: determine the plurality of parent-child node pairs in the similarity tree based on the similar fingerprints of the plurality of data blocks in the first data block set; construct the similarity tree based on the plurality of parent-child node pairs; and use an identifier of the parent node that is of the node corresponding to the target data block and that is in the similarity tree as the identifier of the target reference data block.

Optionally, the information about the similarity tree includes information about the parent-child node pairs in the similarity tree. The determining module 1102 is specifically configured to use an identifier that is of the parent node of the node corresponding to the target data block and that is in the information about the parent-child node pairs as the identifier of the target reference data block.

Optionally, one parent node in the similarity tree includes at least one child node.

Optionally, the obtaining module 1103 is specifically configured to: obtain a second compressed data block from the plurality of compressed data blocks based on the identifier of the target reference data block, where the second compressed data block is obtained by compressing the target reference data block in the first data block set; and decompress the second compressed data block based on the information about the similarity tree, to obtain the target reference data block.

The apparatus 1100 may be implemented in a form of a functional module. The term "module" herein may be implemented in a form of software and/or hardware, and this is not specifically limited.

It should be noted that when the apparatus 1100 provided in the foregoing embodiment performs the foregoing method, division into the foregoing functional modules is merely used as an example for description. During actual application, the foregoing functions may be allocated to different functional modules and implemented based on a requirement, that is, an internal structure of the apparatus is divided into different functional modules to implement all or some of the functions described above. For example, the acquisition module 1101 may be configured to perform any step in the foregoing method, the determining module 1102 may be configured to perform any step in the foregoing method, and the obtaining module 1103 may be configured to perform any step in the foregoing method. Steps that the acquisition module 1101, the determining module 1102, and the obtaining module 1103 are responsible for implementing may be specified based on a requirement. The acquisition module 1101, the determining module 1102, and the obtaining module 1103 separately implement different steps in the foregoing method to implement all functions of the foregoing apparatus.

Modules in the examples described in embodiments of this application can be implemented by electronic hardware or a combination of computer software and electronic hardware. Whether the functions are performed by hardware or software depends on particular applications and design constraints of the technical solutions. A person skilled in the art may use different methods to implement the described functions for each particular application, but it should not be considered that the implementation goes beyond the scope of this application.

In addition, the apparatus embodiments and the method embodiments provided in the foregoing embodiments belong to a same concept. For specific implementation processes thereof, refer to the method embodiments. Details are not described herein again.

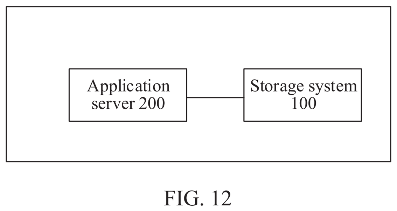

FIG. 12 is a diagram of an architecture of a system according to an embodiment of this application. The system includes an application server 200 and a storage system 100.

In an actual application scenario, a user may access data by using applications. A computer that runs these applications is referred to as the "application server 200". The application server 200 may be a physical machine or a virtual machine. A physical application server 200 includes but is not limited to a desktop computer, a server, a notebook computer, and a mobile device. The application server 200 accesses the storage system 100 through a switch to access data. The switch is an optional device, and the application server 200 may alternatively directly communicate with the storage system 100 over a network.

The storage system 100 includes one or more storages, such as a hard disk, with specific storage functions. An actual address of storage space provided by the storages such as the hard disk is not directly exposed to the application server 200 for use. The hard disk may be of any type. For example, the hard disk may be a solid-state drive, a mechanical hard disk, or a hard disk of another type. Each hard disk is divided into several physical chunks (chunks). These physical chunks are mapped into logical chunks to form a storage pool. The storage pool is used to provide storage space upstream (for example, the application server 200), and the storage space is actually from the hard disk included in the storage system 100.

To reduce storage space occupied by a data copy as much as possible, for example, the storage system 100 may perform the foregoing data compression method to compress user data, and store data after compression (compressed data) in the storage. Alternatively, the storage system 100 acquires stored data after compression (compressed data) from the storage, perform the foregoing data decompression method to decompress the data after the compression to obtain data before the compression, and send the obtained data before the compression to the user. In another example, the application server 200 may perform the foregoing data compression method to compress user data, and store data after compression (compressed data) in the storage system 100. Alternatively, the application server 200 acquires stored data after compression (compressed data) from the storage system 100, perform the foregoing data decompression method to decompress the data after the compression to obtain data before the compression, and send the obtained data before the compression to the user.

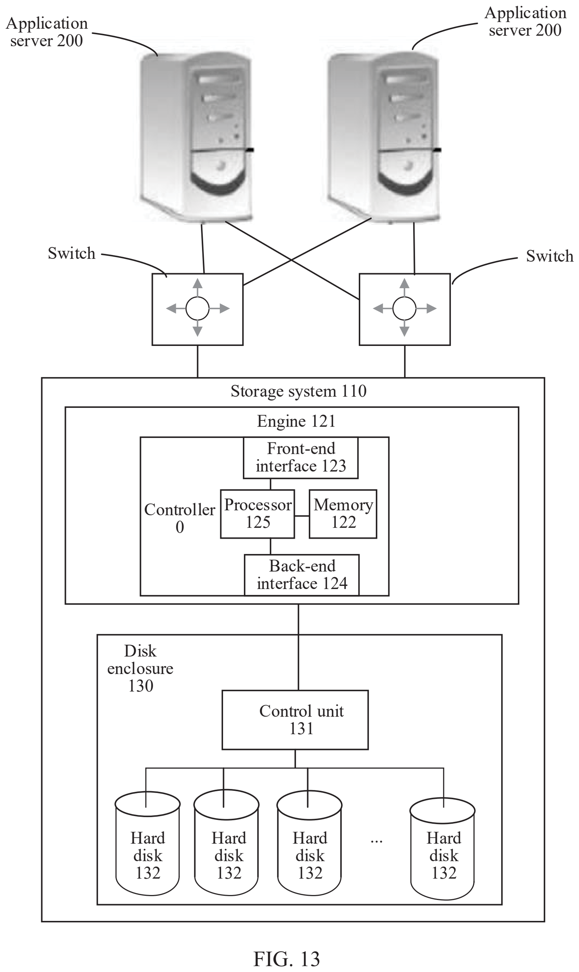

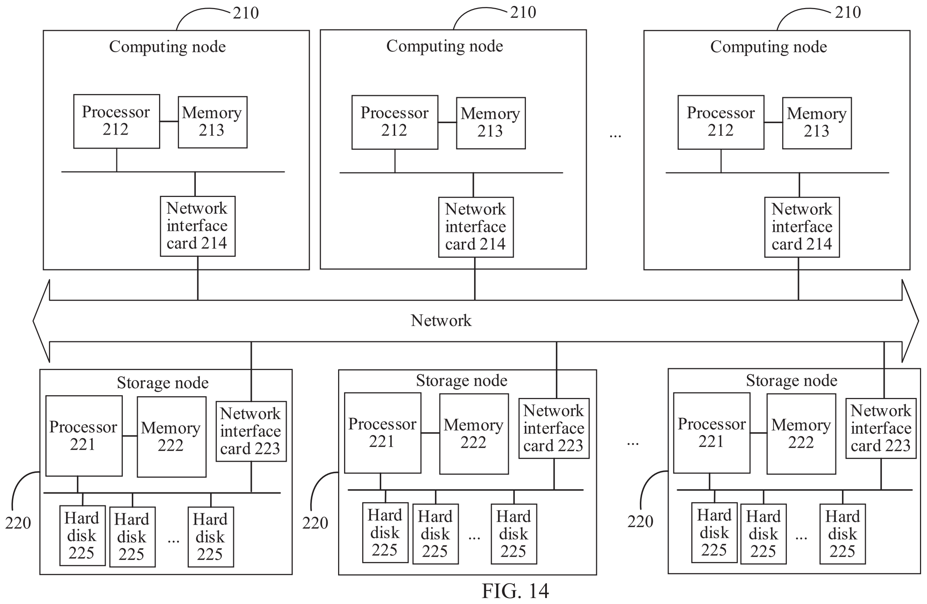

A type of the storage system 100 is not limited in this embodiment of this application. The storage system 100 may be a centralized storage system, or may be a distributed storage system. The following uses FIG. 13 and FIG. 14 as examples to show a possible centralized storage system and a distributed storage system.

It should be understood that, for ease of description, the following uses an example in which the storage system 100 performs the foregoing data compression or data decompression method for description.

FIG. 13 shows a centralized storage system to which an embodiment of this application is applicable. A feature of the centralized storage system is that the centralized storage system has a unified portal, and all data from an external device needs to pass through the portal. The portal is an engine 121 of the centralized storage system. The engine 121 is a most core component of the centralized storage system, and many advanced functions of the storage system are implemented in the engine 121.

As shown in FIG. 13, the engine 121 includes one or more controllers. In FIG. 13, an example in which the engine includes a controller 0 is used for description.

The engine 121 further includes a front-end interface 123 and a back-end interface 124. The front-end interface 123 is configured to communicate with the application server 200, to provide a storage service for the application server 200. The back-end interface 124 is configured to communicate with a hard disk 132 to expand a capacity of the storage system. The engine 121 may be connected to more hard disks 132 through the back-end interface 126, to form an extremely large storage resource pool.

In this embodiment of this application, the controller 0 may perform the data compression method and/or the data decompression method mentioned in embodiments of this application. In other words, the controller 0 may compress user data to obtain data after compression (compressed data), and store the data after the compression (compressed data) in the hard disk 132 in a disk enclosure 130. In this way, the foregoing data compression method is performed. The controller 0 may alternatively acquire data after compression (compressed data) from the hard disk 132 in a disk enclosure 130, decompress the data after the compression to obtain data before the compression, and send the obtained data before the compression to the user. In this way, the foregoing data decompression method is performed.

In terms of hardware, as shown in FIG. 13, the controller 0 includes at least a processor 125 and a memory 122. The processor 125 is a central processing unit (central processing unit, CPU), is configured to process a data access request from the application server, for example, a write data request that is initiated by a user via the application server and that is used to write data, or a read data request that is initiated by a user via the application server and that is used to read data, and is also configured to process a request generated inside the storage system. For example, when receiving, through the front-end port 123, data write requests sent by the application server 200, the processor 125 temporarily stores data in these data write requests in the memory 122. When a total amount of data in the memory 122 reaches a specific threshold, the processor 125 sends, through the back-end port, the data stored in the memory 122 to the hard disk 132 for persistent storage.

The memory 122 is an internal memory that directly exchanges data with the processor, can read/write data at any time at a high speed, and is used as a temporary data memory of an operating system or another running program. The memory may be a random access memory, or may be a read-only memory (read-only memory, ROM). The random access memory may be a dynamic random access memory (dynamic random access memory, DRAM) or a storage class memory (storage class memory, SCM). The DRAM is a semiconductor memory, and is a volatile memory (volatile memory) device similar to most random access memories (random access memories, RAMs). The memory 122 may alternatively be a module including a dual in-line memory module or a dual inline memory module (dual in-line memory module, DIMM), or may be a solid-state drive (solid-state drive, SSD).

The memory 122 stores computer program instructions, and the processor 125 runs the computer program instructions in the memory 122, to perform the data compression method or the data decompression method provided in embodiments of this application.

The engine 121 may not have a hard disk slot, the hard disk 132 needs to be placed in the disk enclosure 130, and the back-end interface 124 communicates with the disk enclosure 130. The back-end interface 124 exists in the engine 121 in a form of an adapter card. One engine 121 may simultaneously use two or more back-end interfaces 124 to connect to a plurality of disk enclosures. Alternatively, an adapter card may be integrated on a mainboard. In this case, the adapter card may communicate with the processor 125 through a PCIE bus.

It should be noted that FIG. 13 shows only one engine 121. However, in actual application, the storage system may include two or more engines 121, and perform redundancy or load balancing between a plurality of engines 121.

The disk enclosure 130 includes a control unit 131 and several hard disks 132. The control unit 131 may have a plurality of forms. In a case, the disk enclosure 130 is a smart disk enclosure. As shown in FIG. 13, the control unit 131 includes a CPU and a memory. The CPU is configured to perform operations such as address translation and data read/write. The memory is configured to temporarily store data that is to be written into the hard disk 132, or data that is read from the hard disk 132 and that is to be sent to the controller. In another case, the control unit 131 is a programmable electronic component, for example, a data processing unit (data processing unit, DPU). Optionally, the DPU herein may alternatively be replaced with a processing chip like a graphics processing unit (graphics processing unit, GPU) or an embedded neural-network processing unit (neural-network processing unit, NPU).

FIG. 14 shows a distributed storage system according to an embodiment of this application. The distributed storage system includes a computing node cluster and a storage node cluster. The computing node cluster includes one or more computing nodes 210 (FIG. 14 shows two computing nodes 210, but is not limited to two computing nodes 210). The computing nodes 210 may communicate with each other. The computing node 210 is a computing device, for example, a server, a desktop computer, or a controller of a storage array.

The computing node 210 may process a data access request from outside of the distributed storage system, for example, a write data request that is initiated by a user via the application server and that is used to write data, or a read data request that is initiated by a user via the application server and that is used to read data, and is also configured to process a request generated inside the storage system.

In terms of hardware, as shown in FIG. 14, the computing node 210 includes at least a processor 212, a memory 213, and a network interface card 214. The processor 212 is a central processing unit (central processing unit, CPU) or another processing chip having a processing function, and is configured to process the data access request from outside of the computing node 210 or the request generated inside the computing node 210. For example, when receiving data write requests sent by the user, the processor 212 temporarily stores data in the data write requests in the memory 213. When a total amount of data in the memory 213 reaches a specific threshold, the processor 212 sends the data stored in the memory 213 to a storage node 220 for persistent storage. FIG. 14 shows only one CPU 212. In actual application, there are usually a plurality of CPUs 212, and one CPU 212 has one or more CPU cores. A quantity of CPUs and a quantity of CPU cores are not limited in this embodiment.

A type of the memory 213 is similar to that of the memory 122 mentioned in the foregoing content. For details, refer to the foregoing descriptions. Details are not described herein again.

The network interface card 214 is configured to communicate with the storage node 220. For example, when the total amount of data in the memory 213 reaches the specific threshold, the computing node 210 may send a request to the storage node 220 via the network interface card 214, to perform persistent storage on the data. In addition, the computing node 210 may further include a bus configured for communication between components inside the computing node 110.

In terms of functions, a main function of the computing node 210 in FIG. 14 is a computing service, and a remote storage may be used to implement persistent storage during data storage. Therefore, the computing node 210 has fewer local storages than a conventional server, so that costs and space are reduced. However, this does not mean that the computing node 210 cannot have a local storage. In actual implementation, the computing node 110 may alternatively have a small quantity of built-in hard disks or a small quantity of external hard disks.

Any computing node 210 may access any storage node 220 in the storage node cluster over a network. The storage node cluster includes a plurality of storage nodes 220 (FIG. 14 shows three storage nodes 220, but is not limited to three storage nodes 220).

The storage node 220 may process a data access request sent by the computing node 210, and write data into a hard disk 225 or read data from the hard disk 225.

In this embodiment of this application, the storage node 220 may perform the data compression method or the data decompression method provided in embodiments of this application.

In terms of hardware, one storage node 220 includes a processor 221, a memory 222, a network interface card 223, and a plurality of hard disks 225. The network interface card 224 is configured to communicate with the computing node 210. The hard disk 225 is configured to store data, and may be a magnetic disk or another type of storage medium, for example, a solid-state drive or a shingled magnetic recording hard disk. The processor 221 is configured to write data into the hard disk 225 or read data from the hard disk 225 based on a read/write data request. In a data read/write process, the processor 221 needs to convert an address carried in the data read/write request into an address that can be identified by the hard disk. In this embodiment of this application, the processor 221 is used as a main core unit of the storage node 220, and performs the data compression method or the data decompression method provided in embodiments of this application.

A type of the processor 221 is similar to a type of the processor 112. For details, refer to the foregoing descriptions. Details are not described herein again.

In another implementation, some functions of the processor 221 may be offloaded to the network interface card 223. The network interface card 223 is an intelligent network interface card, and may include a CPU and a memory. The CPU is configured to perform operations that can be performed by the processor 221, such as address translation and data read/write. The memory in the network interface card is configured to temporarily store data that is to be written into the hard disk 225, or data that is read from the hard disk 225 and that is to be sent to the computing node 210. The CPU may alternatively be a programmable electronic component, for example, a DPU. Optionally, the DPU herein may be a processing chip like a GPU or an NPU. There is no homing relationship between the network interface card 223 and the hard disk 225 in the storage node 220, and the network interface card 223 may access any hard disk 225 in the storage node 210.

It should be noted that FIG. 13 and FIG. 14 show only examples of possible hardware structures of the storage system. The data compression method or the data decompression method provided in embodiments of this application is also applicable to another system or device having a storage function.

In this embodiment, a computer program product including instructions is further provided. The computer program product may be software or a program product that includes the instructions and that can run on a computing device cluster or that can be stored in any usable medium. When the computer program product is run by the computing device cluster, the computing device cluster is enabled to perform the method provided above, or the computing device cluster is enabled to implement functions of the apparatus provided above.

In this embodiment, a computer-readable storage medium is further provided. The computer-readable storage medium may be any usable medium that can be stored by a computing device, or a data storage device like a data center, including one or more usable media. The usable medium may be a magnetic medium (for example, a floppy disk, a hard disk drive, or a magnetic tape), an optical medium (for example, a DVD), a semiconductor medium (for example, a solid-state drive), or the like. The computer-readable storage medium includes instructions. When the instructions in the computer-readable storage medium are executed by the computing device cluster, the computing device cluster is enabled to perform the method provided above.

It should be understood that sequence numbers of the foregoing processes do not mean execution sequences in various embodiments of this application. The execution sequences of the processes should be determined based on functions and internal logic of the processes, and should not be construed as any limitation on the implementation processes of embodiments of this application.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraints of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments according to this application, it should be understood that the disclosed system, apparatus, and method may be implemented in another manner. For example, the described apparatus embodiments are merely examples. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units may be integrated into one unit.

When the functions are implemented in a form of a software functional unit and sold or used as an independent product, the functions may be stored in a computer-readable storage medium. Based on such an understanding, the technical solutions in this application essentially, or the part contributing to the current technology, or some of the technical solutions may be implemented in a form of a software product. The computer software product is stored in a storage medium, and includes several instructions for instructing a computer device (which may be a personal computer, a server, or a network device) to perform all or a part of the steps of the methods described in embodiments of this application. The foregoing storage medium includes any medium that can store program code, such as a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A data compression method, wherein the method comprises:
acquiring a first data block set, wherein the first data block set comprises a plurality of similar data blocks, and the plurality of data blocks comprise a target data block;
determining a target reference data block based on a similarity tree corresponding to the first data block set, wherein the similarity tree is of a tree structure, the similarity tree comprises a plurality of parent-child node pairs, each parent-child node pair indicates two data blocks that meet a similarity condition in the first data block set, the plurality of parent-child node pairs comprise a target parent-child node pair that indicates the target reference data block and the target data block, and a node that is in the target parent-child node pair and that corresponds to the target reference data block is a parent node of a node corresponding to the target data block; and
performing reference-based compression on the target data block based on the target reference data block, to obtain a target data block after the compression.

2. The method according to claim 1, wherein the method further comprises: constructing the similarity tree based on respective similar fingerprints of the plurality of data blocks.

3. The method according to claim 2, wherein the constructing the similarity tree based on the respective similar fingerprints of the plurality of data blocks comprises:
determining the plurality of parent-child node pairs based on the respective similar fingerprints of the plurality of data blocks; and
constructing the similarity tree based on the plurality of parent-child node pairs.

4. The method according to any one of claims 1 to 3, wherein the method further comprises: storing information about the similarity tree in a plurality of compressed data blocks corresponding to the first data block set, wherein the stored information about the similarity tree is used to decompress the plurality of compressed data blocks corresponding to the first data block set.

5. The method according to claim 4, wherein the information about the similarity tree comprises information about the parent-child node pairs in the similarity tree.

6. The method according to claim 4, wherein the information about the similarity tree comprises the similar fingerprints of the data blocks in the first data block set.

7. The method according to any one of claims 1 to 6, wherein one parent node in the similarity tree comprises at least one child node.

8. A data decompression method, wherein the method comprises:
acquiring compressed data, wherein the compressed data comprises a plurality of compressed data blocks corresponding to a first data block set and information about a similarity tree corresponding to the first data block set, the plurality of compressed data blocks comprise a first compressed data block, the first compressed data block is obtained by compressing a target data block in the first data block set, the similarity tree is of a tree structure, the similarity tree comprises a plurality of parent-child node pairs, and each parent-child node pair indicates two data blocks that meet a similarity condition in the first data block set;
determining an identifier of a target reference data block based on the information about the similarity tree, wherein a node corresponding to the target reference data block and a node corresponding to the target data block form a parent-child node pair in the plurality of parent-child node pairs, and the node that is in the target parent-child node pair and that corresponds to the target reference data block is a parent node of the node corresponding to the target data block; and
obtaining the target reference data block based on the identifier of the target reference data block, and decompressing the first compressed data block based on the target reference data block, to obtain the target data block.

9. The method according to claim 8, wherein the information about the similarity tree is stored in any one of the plurality of compressed data blocks.

10. The method according to claim 8 or 9, wherein the information about the similarity tree comprises similar fingerprints of a plurality of data blocks in the first data block set; and
the determining the identifier of the target reference data block based on the information about the similarity tree comprises:
determining the plurality of parent-child node pairs in the similarity tree based on the similar fingerprints of the plurality of data blocks in the first data block set;
constructing the similarity tree based on the plurality of parent-child node pairs; and
using an identifier of the parent node that is of the node corresponding to the target data block and that is in the similarity tree as the identifier of the target reference data block.

11. The method according to claim 8 or 9, wherein the information about the similarity tree comprises information about the parent-child node pairs in the similarity tree; and
the determining the identifier of the target reference data block based on the information about the similarity tree comprises:
using an identifier that is of the parent node of the node corresponding to the target data block and that is in the information about the parent-child node pairs as the identifier of the target reference data block.

12. The method according to any one of claims 8 to 11, wherein one parent node in the similarity tree comprises at least one child node.

13. The method according to any one of claims 8 to 12, wherein the obtaining the target reference data block based on the identifier of the target reference data block comprises:
obtaining a second compressed data block from the plurality of compressed data blocks based on the identifier of the target reference data block, wherein the second compressed data block is obtained by compressing the target reference data block in the first data block set; and
decompressing the second compressed data block based on the information about the similarity tree, to obtain the target reference data block.

14. A data compression apparatus, comprising:
an acquisition module, configured to acquire a first data block set, wherein the first data block set comprises a plurality of similar data blocks, and the plurality of data blocks comprise a target data block;
a determining module, configured to determine a target reference data block based on a similarity tree corresponding to the first data block set, wherein the similarity tree is of a tree structure, the similarity tree comprises a plurality of parent-child node pairs, each parent-child node pair indicates two data blocks that meet a similarity condition in the first data block set, the plurality of parent-child node pairs comprise a target parent-child node pair that indicates the target reference data block and the target data block, and a node that is in the target parent-child node pair and that corresponds to the target reference data block is a parent node of a node corresponding to the target data block; and
a compression module, configured to perform reference-based compression on the target data block based on the target reference data block, to obtain a target data block after the compression.

15. The apparatus according to claim 14, wherein the apparatus further comprises:
a construction module, configured to construct the similarity tree based on respective similar fingerprints of the plurality of data blocks.

16. The apparatus according to claim 15, wherein the construction module is specifically configured to:
determine the plurality of parent-child node pairs based on the respective similar fingerprints of the plurality of data blocks; and
construct the similarity tree based on the plurality of parent-child node pairs.

17. The apparatus according to any one of claims 14 to 16, wherein the apparatus further comprises:
a storage module, configured to store information about the similarity tree in a plurality of compressed data blocks corresponding to the first data block set, wherein the stored information about the similarity tree is used to decompress the plurality of compressed data blocks corresponding to the first data block set.

18. The apparatus according to claim 17, wherein the information about the similarity tree comprises information about the parent-child node pairs in the similarity tree.

19. The apparatus according to claim 17, wherein the information about the similarity tree comprises the similar fingerprints of the data blocks in the first data block set.

20. The apparatus according to any one of claims 14 to 19, wherein one parent node in the similarity tree comprises at least one child node.

21. A data decompression apparatus, comprising:
an acquisition module, configured to acquire compressed data, wherein the compressed data comprises a plurality of compressed data blocks corresponding to a first data block set and information about a similarity tree corresponding to the first data block set, the plurality of compressed data blocks comprise a first compressed data block, the first compressed data block is obtained by compressing a target data block in the first data block set, the similarity tree is of a tree structure, the similarity tree comprises a plurality of parent-child node pairs, and each parent-child node pair indicates two data blocks that meet a similarity condition in the first data block set;
a determining module, configured to determine an identifier of a target reference data block based on the information about the similarity tree, wherein a node corresponding to the target reference data block and a node corresponding to the target data block form a parent-child node pair in the plurality of parent-child node pairs, and the node that is in the target parent-child node pair and that corresponds to the target reference data block is a parent node of the node corresponding to the target data block; and
an obtaining module, configured to: obtain the target reference data block based on the identifier of the target reference data block, and decompress the first compressed data block based on the target reference data block, to obtain the target data block.

22. The apparatus according to claim 21, wherein the information about the similarity tree is stored in any one of the plurality of compressed data blocks.

23. The apparatus according to claim 21 or 22, wherein the information about the similarity tree comprises similar fingerprints of a plurality of data blocks in the first data block set; and
the determining module is specifically configured to:
determine the plurality of parent-child node pairs in the similarity tree based on the similar fingerprints of the plurality of data blocks in the first data block set;
construct the similarity tree based on the plurality of parent-child node pairs; and
use an identifier of the parent node that is of the node corresponding to the target data block and that is in the similarity tree as the identifier of the target reference data block.

24. The apparatus according to claim 21 or 22, wherein the information about the similarity tree comprises information about the parent-child node pairs in the similarity tree; and
the determining module is specifically configured to:
use an identifier that is of the parent node of the node corresponding to the target data block and that is in the information about the parent-child node pairs as the identifier of the target reference data block.

25. The apparatus according to any one of claims 21 to 24, wherein one parent node in the similarity tree comprises at least one child node.

26. The apparatus according to any one of claims 21 to 25, wherein the obtaining module is specifically configured to:
obtain a second compressed data block from the plurality of compressed data blocks based on the identifier of the target reference data block, wherein the second compressed data block is obtained by compressing the target reference data block in the first data block set; and
decompress the second compressed data block based on the information about the similarity tree, to obtain the target reference data block.

27. A storage system, comprising a controller and a storage, wherein the controller is configured to: perform the method according to any one of claims 1 to 13; and store compressed data in the storage, or acquire the compressed data from the storage.

28. A computing device, wherein the computing device comprises a processor and a storage; and
the processor is configured to execute instructions stored in the storage, to enable the computing device to perform the method according to any one of claims 1 to 13.

29. A computer program product comprising instructions, wherein when the instructions are run by a computing device, the computing device is enabled to perform the method according to any one of claims 1 to 13.

30. A computer-readable storage medium, comprising computer program instructions, wherein when the computer program instructions are executed by a computing device, the computing device is enabled to perform the method according to any one of claims 1 to 13.
